# EUROPEAN PATENT SPECIFICATION

(11) **EP 2 548 224 B1**
(45) Date of publication and mention of the grant of the patent: **09.09.2015**
(21) Application number: 10847647.4
(22) Date of filing: 18.03.2010
(51) Int. Cl.: H01L 23/427

(54) **COOLING ASSEMBLY FOR COOLING HEAT GENERATING COMPONENT**
KÜHLANORDNUNG ZUR KÜHLUNG EINER WÄRMEERZEUGUNGSKOMPONENTE
ENSEMBLE DE REFROIDISSEMENT POUR REFROIDIR UN COMPOSANT PRODUISANT DE LA CHALEUR

(43) Date of publication of application: 23.01.2013
(73) Proprietor: Telefonaktiebolaget L M Ericsson (publ), 164 83 Stockholm (SE)
(72) Inventor: YUAN, Haibo, Beijing 100102 (CN)
(74) Representative: Lind, Robert
(86) International application number: PCT/CN2010/000330
(87) International publication number: WO 2011/113178

(56) References cited:
- CN-C- 1 301 553
- CN-C- 100 547 770
- CN-Y- 2 739 795
- CN-Y- 201 115 192
- DE-U1-202009 010 525
- US-A- 6 163 073
- US-A1- 2009 025 909
- US-A1- 2009 084 529
- US-B1- 6 717 813

## Description

### TECHNICAL FIELD

The present invention relates to a cooling assembly for cooling a heat generating component, and a method of manufacturing a cooling assembly for cooling a heat generating component, as well as a cooling arrangement comprising such a cooling assembly, wherein the cooling assembly comprises a heat sink, at least one thermally conductive plate, at least one elongated heat conductor with elongated shape as well as a plurality of fins.

### BACKGROUND

When products comprising electronic equipment are manufactured today, heat dissipation is an important issue. In order to manufacture more compact products, the components inside the electronic equipment have a smaller size, but they still dissipate high amounts of heat that have to be dealt with. Further, the products must not be too heavy, and must function in an outdoor environment. Thus, when manufacturing cooling assemblies for cooling of electronic equipment, the volume and the weight should be considered, and they also have to be able to efficiently dissipate high amounts of heat in an environment where they are exposed to rain, sun etc.

An example of electronic equipment that has to be efficiently cooled is a remote radio unit (RRU) in a radio base station (RBS). These RRUs are normally installed outdoors on top of a tower or pole, which means that the requirements for volume and weight are critical, as well as they have to withstand a harsh outdoor environment. Since a long life time is desirable for the cooling assembly of the RRU, a cooling by natural convection is preferred. When cooling by forced convection is applied, the use of e.g. a fan is necessary, and a fan is not able to withstand a long lifetime in an outdoor environment.

The heat generation of the RRU itself may from time to time be over 400 W. Further, a power amplifier board is located in the RRU, and the power amplifier will generate a high amount of heat while working. The generation of heat from the power amplifier board may reach over 150 W/cm².

WO 2005/089197 A2 describes a power amplifier assembly that comprises an electronics module, a finned heat sink and a heat pipe enhanced pallet, where the electronics module is mounted on the pallet and the pallet is mounted on the finned heat sink. On the power amplifier are components that dissipate heat mounted. The components are attached to a copper tungsten flange to facilitate the heat conduction to the heat sink and the heat pipe.

This known power amplifier assembly is only able to dissipate limited amounts of heat and is relatively heavy. Further, the thermal resistance of the copper tungsten flange will decrease the heat transfer rate of the heat pipe. Thus, there is a need for an improved cooling assembly.

US2009/0084529 discloses a cooler module. DE202009010525 discloses a thermally conductive module. US2009/025909 discloses a cooler module.

### SUMMARY

The object of the present invention is to address the problem outlined above, and this object and others are achieved by the apparatus and the method according to the appended independent claims, and by the embodiments according to the dependent claims.

According to a first aspect, the invention provides a cooling assembly for cooling of a heat generating component. The cooling assembly comprises a heat sink with a first side adapted to face the heat generating component and a second side that is opposite the first side. Further, the cooling assembly comprises at least one thermally conductive plate at least partly embedded into the heat sink on the first side and at least one of the heat conductors is adapted to be in direct thermal contact with the heat generating component. The cooling assembly comprises at least one heat conductor with an elongated shape and where the heat conductor is partly embedded into the first side of the heat sink and partly embedded in the conductive plate. The cooling assembly comprises a plurality of fins protruding from the second side of the heat sink.

Thus, an advantage with the cooling assembly is that the heat generating component is efficiently cooled by a combination of the heat sink, the thermally conductive plate, the elongated heat conductor and the cooling fins. Since the plate is embedded into the heat sink the cooling assembly gets a compact design. By letting the heat conductor be in direct thermal contact with the heat generating component, the heat transfer rate of the heat conductor will be efficient, which is advantageously.

At least one of the heat conductors may be a heat pipe. In order to have a high heat transfer rate in the heat pipe from the heat generating component, at a hot region of the heat sink, to a cooler region of the heat sink, the heat pipe or heat pipes may be adapted to be in direct thermal contact with the heat generating component. A direct thermal contact between the heat generating component and the heat pipe has the advantage that it leads to efficient cooling of the heat generating component.

Normally, when using heat pipes in cooling applications, there might be problems during a cold start when the material used inside the heat pipe may freeze. In this cooling assembly the heat pipe will not be disabled during cold start even if the liquid material inside has frozen. Thus, it is advantageously using a heat pipe in the assembly according to the application, since the cooling will be enabled even if the heat pipe is frozen, i.e. the heat pipe will have a cooling capacity as a heat sink.

The thickness of the heat sink may be non uniform. Further, a region of the heat sink may have a greater thickness and this region may at least comprise the location of the plate, which also may be the region of the heat sink that is closest to the heat generating component. The region of the heat sink with greater thickness may extend between two opposite substantially parallel edges, but the region may also extend in another direction. The thickness of the heat sink may decrease continuously in a direction parallel to the said two opposite edges, or the thickness may decrease in another direction.

When the heat conductor is a heat pipe at least a part of this heat pipe may be embedded into the plate. This design is advantageously in order to be able to manufacture a compact and efficient cooling assembly.

The fins may extend between two opposite substantially parallel edges. As is the case with the region of the heat sink that is thicker, the fins may also extend in another direction. But the manufacturing of the cooling assembly is most efficient when the fins and the thicker region of the heat sink extend in the same direction, e.g. between the said two edges.

The fins may be spaced apart with a distance of approximately 10 to 14 mm. Thereby is the air flow around the cooling assembly optimized, which leads to the most efficient cooling, and thus is advantageously.

Further, the plate may have a greater area than the heat generating component. Depending on the amount of heat generated by the heat generating component, the plate may not necessarily have a greater area, and the area may e.g. have substantially the same area as the heat generating component. Thus, it is an advantage that depending on the amount of heat generated the size of the plate may be varied.

The plate may be made of copper, but could also be manufactured in any other appropriate material with a high heat transfer rate, in order to efficiently lead away heat from the heat generating component. The material could also be another material e.g. tungsten or a mixture of different materials.

The heat sink may be made of aluminum or magnesium. The fins may also be made of aluminum or magnesium. Other light weight materials with an acceptable heat transfer rate are also possible to use when manufacturing the heat sink and the fins. Since the heat sink and the fins form large parts of the cooling assembly, a main issue when choosing material for these parts is the weight of the materials. However, they should also have a good enough heat transfer rate to be able to lead away heat from the heat generating component.

According to a second aspect, the invention provides a cooling arrangement that comprises a heat generating component attached to the cooling assembly, according to the first aspect.

According to a third aspect, the invention provides a method of manufacturing a cooling assembly. The method comprises providing a heat sink with a plurality of fins protruding from one side of the heat sink and embedding a plate in the heat sink on the side of the heat sink that is opposite the side from which the fins protrude. The method further comprises providing elongated grooves on the plate and the side of the heat sink that is opposite the side from which the fins protrude. The method also comprises inserting elongated heat conductors into the grooves and attaching the heat conductors to the heat sink. The method further comprises filling the gaps around the heat conductors and machining the surface of the side of the heat sink that is opposite the side from which the fins protrude. Thus, the cooling assembly is manufactured in an efficient way, which may limit the costs of production and thus, is an advantage of the invention.

The method may further comprise attaching a heat generating component to the cooling assembly so the heat generating component is in direct thermal contact with the plate and the heat conductors. This has the advantage to more efficiently lead away the heat from the heat generating component.

The method may also comprise attaching of the heat conductors to the heat sink by welding and filling the gaps around the heat conductors with solder. This leads to a good thermal contact, which is a further advantage.

### BRIEF DESCRIPTION OF THE DRAWINGS

The present invention will now be described in more detail, and with reference to the accompanying drawings, in which:
- Figure 1 illustrates a perspective view of the cooling assembly;
- Figure 2 illustrates a cross sectional view of a part of the cut along A-A in figure 1, and where the fins are omitted;

### DETAILED DESCRIPTION

In the following description, the invention will be described in more detail with reference to certain embodiments and to the accompanying drawings. For purposes of explanation and not limitation, specific details are set forth, such as particular scenarios, techniques, etc., in order to provide a thorough understanding of the present invention. However, it is apparent to one skilled in the art that the present invention may be practised in other embodiments that depart from these specific details.

A basic idea with the invention is to efficiently cool a heat generating component by a cooling assembly comprising a heat sink, at least one thermally conductive plate, at least one elongated heat conductor and a plurality of fins. The cooling assembly should have a light weight and should be able to efficiently cool a component in an outdoor environment. The heat generating component may e.g. be the electronic equipment in a remote radio unit in a radio base station or the electronic equipment in any other product that is used outdoors or elsewhere.

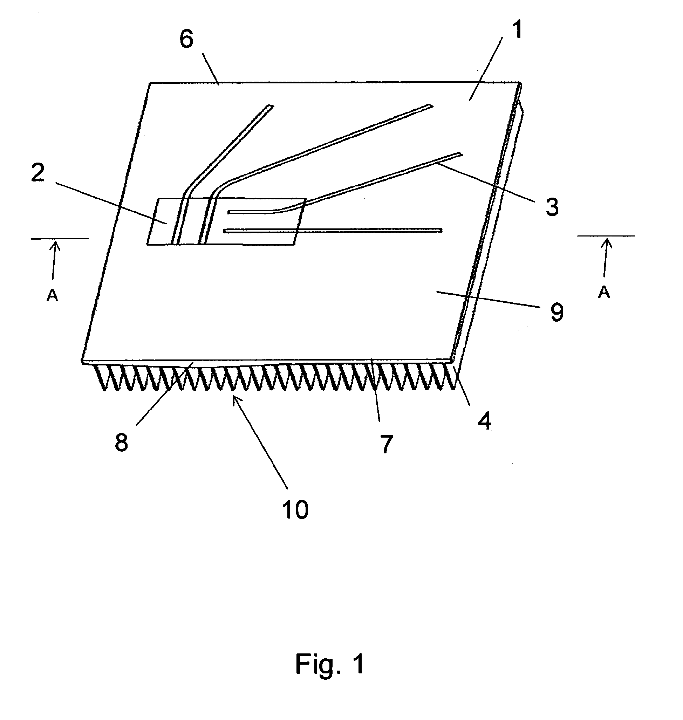

Figure 1 illustrates an exemplary embodiment of the cooling assembly in a perspective view. In one embodiment, the heat sink 1 is made of aluminum or magnesium and the fins 4 are made of aluminum or magnesium as well. In another embodiment, the heat sink 1 and the fins 4 are made of another light weight material with a certain heat transfer rate. The heat sink 1 and the fins 4 may be manufactured by the same material or by different materials.

As can be seen in figure 1, the heat sink and the fins constitute a large part of the cooling assembly. Therefore, the weight of the materials chosen for these parts is preferable comparatively low. Another aspect is the heat transfer rate, and since the heat sink and the fins should be able to transfer heat away from the heat generating component, their heat transfer rate is preferable comparatively high.

The heat sink 1 has a first side 9 and a second side 10 that is opposite the first side. The heat sink has two opposite substantially parallel edges 6 and 7.

Figure 1 shows an exemplary embodiment of the invention where the cooling assembly comprises four heat conductors 3 with elongated shape. The number of heat conductors may be greater or lower, depending on the amount of heat that must be dissipated. These elongated heat conductors 3 are preferably made of a material with a high heat transfer rate, e.g. copper. The heat conductors 3 are embedded in the first side 9 of the heat sink so that one end of the heat conductors is able to be in direct thermal contact with the heat generating component 5. The elongated heat conductors 3 transfer heat from the end, which is in direct thermal contact with the heat generating component, to the other end of the elongated heat conductors 3, i.e. to the end which is situated at a cooler region of the heat sink 1. The thermally conductive plate 2 is preferably also made of a material with a great heat transfer rate, e.g. copper.

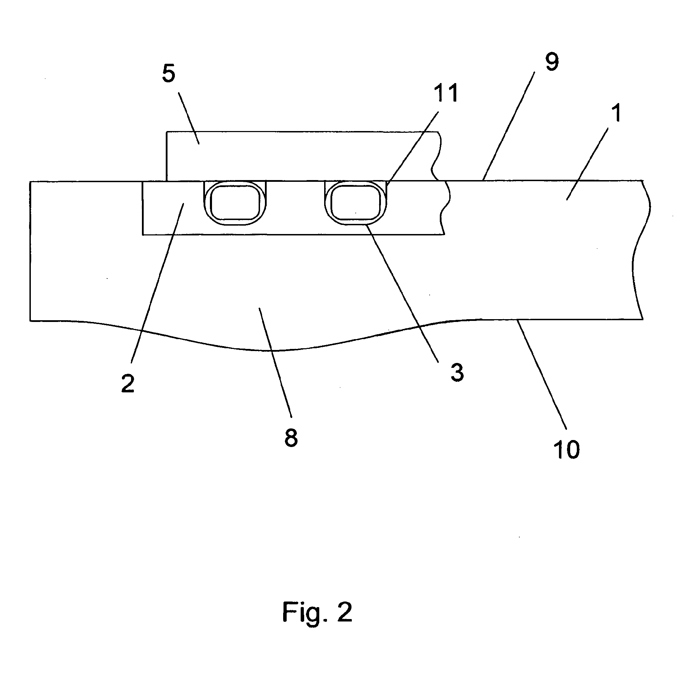

Figure 2 illustrates a cross sectional view of a part of the cooling assembly along A-A in figure 1. The fins have been omitted for the sake of clarity. In a preferred embodiment, the area of the thermally conductive plate 2 is greater than the area of the heat generating component 5. The size of the plate depends on the amount of heat generated by the heat generating component. According to an exemplary embodiment, the area is substantially the same as the area of the heat generating component. According to another exemplary embodiment, which is not illustrated in figure 2, the area is smaller than the area of the heat generating component. In the preferred embodiment of the invention shown in figure 2, the plate 2 is embedded in the heat sink 1, so that the surface of the thermally conductive plate 2 is flush with the first side 9 of the heat sink. According to another exemplary embodiment, the plate is only partly embedded in the heat sink.

In order to achieve a good direct thermal contact between the heat generating component 5 and the heat conductors 3 no air gaps are allowed in the cooling assembly. As illustrated in the preferred embodiment of the invention in figure 2, the gaps around the heat conductors 3 are filled with a bonding material 11.

As described above, the figures 1 and 2 show a cooling assembly according to an exemplary embodiment of the invention. The drawings show a plurality of elongated heat conductors 3. However, the invention is not limited to a plurality of heat conductors, instead, depending on the amount of generated heat, there might be a fewer number of heat conductors 3, e.g. only one heat conductor. The elongated heat conductor transfers heat from a hot region of the heat sink to a cooler region, thus it is preferably made of a material with a high heat transfer rate e.g. copper. According to an exemplary embodiment, at least one of the heat conductors 3 is a heat pipe. A heat pipe is an efficient cooling component that consists of an elongated hollow member, e.g. a pipe, which is manufactured in a material with a high heat transfer rate and filled with a liquid material that is able to condense at the hot end and evaporate at the cold end. The material of the heat pipe is e.g. copper, or any other material with a high heat transfer rate and the liquid material is for example water.

The cooling assembly according to the exemplary embodiment of the invention illustrated in figures 1 and 2 has a region 8 with a greater thickness, comprising the location of the plate 2. This region extends between the two opposite edges 6 and 7, and the thickness of the region decreases continuously in a direction parallel to the said two opposite edges 6 and 7.

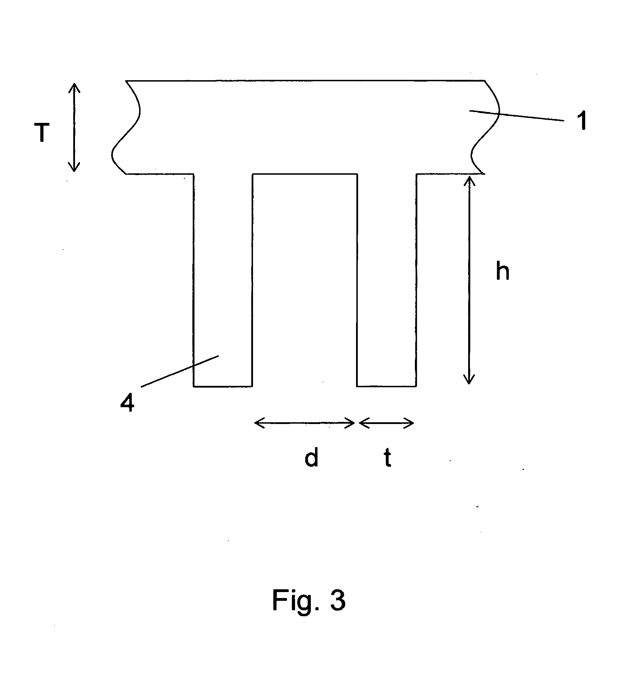

Figure 3 illustrates a cross section of a part of an exemplary heat sink with fins where the thickness T of the heat sink is shown at a region that does not comprise the region 8, i.e. a part of the heat sink near the edges. The area of the fins 4 is preferably as large as possible in order to spread the heat from the heat generating component 5. According to an exemplary embodiment of the invention, the fins are spaced apart with a distance d of approximately 10 to 14 mm, which is ideal for optimizing the air flow around the heat sink, and leads to the most efficient cooling by natural convection. However, another distance between two subsequent fins is also possible. The thickness t of the fins 4 is preferably as thin as possible. Depending on the manufacturing technique, the thickness is e.g. 1 and 2 mm. The height h of the fins 4 also depends on the technique of manufacturing. The height is preferably within a range from e.g. 60 to 120 mm. The length of the fins 4, i.e. the distance between the two opposite edges 6 and 7, in the exemplary embodiment of the invention shown in figure 1, is e.g. between 300 and 700 mm. The thickness T of the heat sink 1 near the edges is e.g. 7 to 10 mm, and according to an exemplary embodiment, the thickness increases continuously towards the region 8, which is e.g. about twice as thick as the heat sink near the edges.

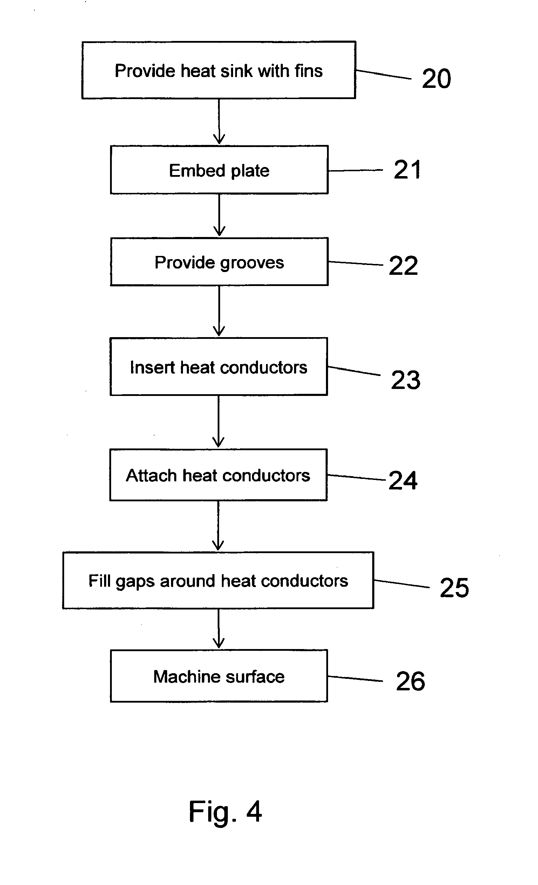

Figure 4 is a flowchart illustrating an exemplary method of manufacturing a cooling assembly, according to the invention. In one preferred embodiment, the heat sink 1 and the fins 4 are manufactured by extrusion. This technique is e.g. used when the material of the heat sink and the fins is aluminum. In another preferred embodiment, the heat sink 1 and the fins 4 are manufactured by die casting. This technique is e.g. used when the material of the heat sink and the fins is magnesium. Other manufacturing techniques to provide, in step 20, the heat sink 1 with the fins 4 protruding from the second side 10 are also possible.

The thermally conductive plate 2 is embedded, in step 21, in the heat sink 1 on the first side 9 by machining a recess in the heat sink with the size of the plate 2, and thereafter embedding the plate 2 in the recess. According to a further exemplary embodiment, the recess is treated with a bonding material with a high heat transfer rate, such as thermally conductive epoxy or solder, before embedding the plate, in order to achieve a good thermal contact between the plate and the heat sink. After the plate has been embedded, grooves are provided, in step 22, on the first side 9 of the heat sink. The grooves are machined and may also be treated with a bonding material with a high heat transfer rate before the heat conductors 3 are inserted, in step 23, into the grooves. The heat conductors 3 are attached, in step 24, to the heat sink 1 by means of a bonding material, e.g. by welding.

The gaps around the heat conductors 3 are filled, in step 25, by a bonding material, e.g. solder. Figure 2 illustrates the bonding material 11 at the heat conductors 3. The surface of the first side 9 of the heat sink 1 is machined, in step 26, to achieve a flat surface. Thereafter, the heat generating component 5 is attached in direct thermal contact with the thermally conductive plate 2, as well as with the heat conductors 3.

In order to ensure an efficient cooling assembly, and to assure a good thermal contact between the heat generating component 5 and the plate 2, as well as the heat conductors 3, it is important that no air voids remain in the assembly. Preferably, all air voids should be filled with a thermal conductive bonding material, such as solder, weld, thermally conductive epoxy or any other suitable bonding material.

Further, the above mentioned and described embodiments are only given as examples and should not be limiting to the present invention. Other solutions, uses, objectives, and functions within the scope of the invention as claimed in the accompanying patent claims should be apparent for the person skilled in the art.

## Claims

1. Cooling assembly for cooling of a heat generating component (5), the cooling assembly comprising:
a heat sink (1) with a first side (9) adapted to face the heat generating component (5) and a second side (10) that is opposite the first side;
at least one thermally conductive plate (2) at least partly embedded into the heat sink (1) on the first side (9) and adapted to be in direct thermal contact with the heat generating component (5);
at least one heat conductor (3) with an elongated shape adapted to be in direct thermal contact with the heat generating component (5); and
a plurality of fins (4) protruding from the second side (10) of the heat sink (1);
**characterized in that** the heat conductor (3) is partly embedded into the first side (9) of the heat sink (1) and partly embedded in the conductive plate.

2. Cooling assembly according to claim 1, **characterized in that** at least one of the heat conductors (3) is a heat pipe.

3. Cooling assembly according to claims 1 or 2, **characterized in that** the heat sink (1) has a non uniform thickness.

4. Cooling assembly according to any of the preceding claims, **characterized in that** the heat sink (1) has a region (8) that has a greater thickness, which region (8) at least comprises the location of the plate (2).

5. Cooling assembly according to claim 4, **characterized in that** the region (8) of the heat sink (1) with greater thickness extends between two opposite substantially parallel edges (6, 7) of the heat sink (1).

6. Cooling assembly according to claim 5, **characterized in that** the thickness of the heat sink (1) decreases continuously in a direction parallel to the said two opposite edges (6, 7).

7. Cooling assembly according to any of the preceding claims, **characterized in that** the fins (4) extend between two opposite substantially parallel edges (6, 7) of the heat sink (1).

8. Cooling assembly according to any of the preceding claims, **characterized in that** the plate (2) has a greater area than the heat generating component (5).

9. Cooling assembly according to any of the preceding claims, **characterized in that** the plate (2) is made of copper.

10. Cooling assembly according to any of the preceding claims, **characterized in that** the heat sink (1) is made of aluminum or magnesium.

11. Method of manufacturing a cooling assembly, comprising:
- providing (20) a heat sink (1) with a plurality of fins (4) protruding from one side (10) of the heat sink (1);
- at least partly embedding (21) a thermally conductive plate (2) in the heat sink (1) on the side (9) of the heat sink (1) that is opposite the side (10) from which the fins (4) protrude;
- providing (22) elongated grooves on the plate and the side (9) of the heat sink (1) that is opposite the side (10) from which the fins (4) protrude;
- inserting (23) at least one elongated heat conductor (3) into the grooves such that the heat conductor is partly embedded into the first side of the heat sink and partly embedded in the conductive plate,
- attaching (24) the heat conductors (3) to the heat sink (1);
- filling (25) gaps around the heat conductors (3); and
- machining (26) the surface of the side (9) of the heat sink (1) that is opposite the side (10) from which the fins (4) protrude.

12. Method according to claim 11, wherein the method further comprises attaching a the heat generating component (5) to the cooling assembly so the heat generating component (5) is in direct thermal contact with the plate (2) and the heat conductors (3).

13. Method according to claims 11 or 12, wherein the heat conductors (3) are attached to the heat sink (1) by welding.

14. Method according to any of claims 11 to 13, wherein the gaps around the heat conductors (3) are filled with solder.

## Patentansprüche

1. Kühlbaugruppe zum Kühlen einer Wärme erzeugenden Komponente (5), wobei die Kühlbaugruppe Folgendes umfasst:
eine Wärmesenke (1) mit einer ersten Seite (9), die dafür eingerichtet ist, zu der Wärme erzeugenden Komponente (5) zu zeigen, und einer zweiten Seite (10), die der ersten Seite entgegengesetzt ist,
wenigstens eine wärmeleitfähige Platte (2), die wenigstens teilweise auf der ersten Seite (9) in die Wärmesenke (1) eingebettet und dafür eingerichtet ist, in unmittelbarem thermischen Kontakt mit der Wärme erzeugenden Komponente (5) zu stehen,
wenigstens einen Wärmeleiter (3) mit einer länglichen Form, der dafür eingerichtet ist, in unmittelbarem thermischen Kontakt mit der Wärme erzeugenden Komponente (5) zu stehen, und
mehrere Rippen (4), die von der zweiten Seite (10) der Wärmesenke (1) vorspringen,
**dadurch gekennzeichnet, dass** der Wärmeleiter (3) teilweise in die erste Seite (9) der Wärmesenke (1) eingebettet und teilweise in der leitfähigen Platte eingebettet ist.

2. Kühlbaugruppe nach Anspruch 1, **dadurch gekennzeichnet, dass** wenigstens einer von den Wärmeleitern (3) ein Wärmerohr ist.

3. Kühlbaugruppe nach Anspruch 1 oder 2, **dadurch gekennzeichnet, dass** die Wärmesenke (1) eine ungleichförmige Dicke hat.

4. Kühlbaugruppe nach einem der vorhergehenden Ansprüche, **dadurch gekennzeichnet, dass** die Wärmesenke (1) einen Bereich (8) hat, der eine größere Dicke hat, wobei der Bereich (8) wenigstens die Position der Platte (2) umfasst.

5. Kühlbaugruppe nach Anspruch 4, **dadurch gekennzeichnet, dass** sich der Bereich (8) der Wärmesenke (1) mit größerer Dicke zwischen zwei gegenüberliegenden, im Wesentlichen parallelen Kanten (6, 7) der Wärmesenke (1) erstreckt.

6. Kühlbaugruppe nach Anspruch 5, **dadurch gekennzeichnet, dass** die Dicke der Wärmesenke (1) in einer Richtung, parallel zu den zwei gegenüberliegenden Kanten (6, 7), kontinuierlich abnimmt.

7. Kühlbaugruppe nach einem der vorhergehenden Ansprüche, **dadurch gekennzeichnet, dass** sich die Rippen (4) zwischen zwei gegenüberliegenden, im Wesentlichen parallelen Kanten (6, 7) der Wärmesenke (1) erstrecken.

8. Kühlbaugruppe nach einem der vorhergehenden Ansprüche, **dadurch gekennzeichnet, dass** die Platte (2) eine größere Fläche hat als die Wärme erzeugende Komponente (5).

9. Kühlbaugruppe nach einem der vorhergehenden Ansprüche, **dadurch gekennzeichnet, dass** die Platte (2) aus Kupfer hergestellt ist.

10. Kühlbaugruppe nach einem der vorhergehenden Ansprüche, **dadurch gekennzeichnet, dass** die Wärmesenke (1) aus Aluminium oder Magnesium hergestellt ist.

11. Verfahren zum Herstellen einer Kühlbaugruppe, das Folgendes umfasst
- das Bereitstellen (20) einer Wärmesenke (1) mit mehreren Rippen (4), die von einer Seite (10) der Wärmesenke (1) vorspringen,
- das wenigstens teilweise Einbetten (21) einer wärmeleitfähigen Platte (2) in der Wärmesenke (1) auf der Seite (9) der Wärmesenke (1), die der Seite (10), von der die Rippen (4) vorspringen, entgegengesetzt ist,
- das Bereitstellen (22) von länglichen Rillen an der Platte und der Seite (9) der Wärmesenke (1), die der Seite (10), von der die Rippen (4) vorspringen, entgegengesetzt ist,
- das Einsetzen (23) wenigstens eines länglichen Wärmeleiters (3) in die Rillen derart, dass der Wärmeleiter teilweise in die erste Seite der Wärmesenke und tellweise in der leitfähigen Platte eingebettet ist,
- das Befestigen (24) der Wärmeleiter (3) an der Wärmesenke (1),
- das Füllen (25) von Lücken um die Wärmeleiter (3) und
- das maschinelle Bearbeiten (26) der Oberfläche der Seite (9) der Wärmesenke (1), die der Seite (10), von der die Rippen (4) vorspringen, entgegengesetzt ist.

12. Verfahren nach Anspruch 11, wobei das Verfahren ferner das Befestigen einer Wärme erzeugenden Komponente (5) an der Kühlbaugruppe, so dass die Wärme erzeugende Komponente (5) in unmittelbarem thermischen Kontakt mit der Platte (2) und den Wärmeleitern (3) steht.

13. Verfahren nach Anspruch 11 oder 12, wobei die Wärmeleiter (3) durch Schweißen an der Wärmesenke (1) befestigt werden.

14. Verfahren nach einem der Ansprüche 11 bis 13, wobei die Lücken um die Wärmeleiter (3) mit Lot gefüllt werden.

## Revendications

1. Assemblage de refroidissement pour refroidir un composant de génération de chaleur (5), l'assemblage de refroidissement comprenant :
un dissipateur de chaleur (1), comportant un premier côté (9) adapté pour faire face au composant de génération de chaleur (5), et un deuxième côté (10) opposé au premier côté ;
au moins une plaque à conductivité thermique (2), encastrée au moins partiellement dans le dissipateur de chaleur (1) sur le premier côté (9), et adaptée pour être en contact thermique direct avec le composant de génération de chaleur (5) ;
au moins un conducteur de chaleur (3), ayant une forme allongée, adapté pour être en contact thermique direct avec le composant de génération de chaleur (5) ; et
plusieurs ailettes (4), débordant du deuxième côté (10) du dissipateur de chaleur (1) ;
**caractérisé en ce que** le conducteur de chaleur (3) est encastré en partie dans le premier côté (9) du dissipateur de chaleur (1) et est encastré en partie dans la plaque conductrice.

2. Assemblage de refroidissement selon la revendication 1, **caractérisé en ce qu'**au moins un des conducteurs de chaleur (3) est un caloduc.

3. Assemblage de refroidissement selon les revendications 1 ou 2, **caractérisé en ce que** le dissipateur de chaleur (1) a une épaisseur non uniforme.

4. Assemblage de refroidissement selon l'une quelconque des revendications précédentes, **caractérisé en ce que** le dissipateur de chaleur (1) comporte une région (8) ayant une épaisseur accrue, cette région (8) comprenant au moins l'emplacement de la plaque (2).

5. Assemblage de refroidissement selon la revendication 4, **caractérisé en ce que** la région (8) du dissipateur de chaleur (1) à épaisseur accrue s'étend entre deux bords opposés essentiellement parallèles (6, 7) du dissipateur de chaleur (1).

6. Assemblage de refroidissement selon la revendication 5, **caractérisé en ce que** l'épaisseur du dissipateur de chaleur (1) est réduite de manière continue dans une direction parallèle aux dits deux bords opposés (6, 7).

7. Assemblage de refroidissement selon l'une quelconque des revendications précédentes, **caractérisé en ce que** les ailettes (4) s'étendent entre deux bords opposés essentiellement parallèles (6, 7) du dissipateur de chaleur (1).

8. Assemblage de refroidissement selon l'une quelconque des revendications précédentes, **caractérisé en ce que** la plaque (2) a une surface supérieure à celle du composant de génération de chaleur (5).

9. Assemblage de refroidissement selon l'une quelconque des revendications précédentes, **caractérisé en ce que** la plaque (2) est composée de cuivre.

10. Assemblage de refroidissement selon l'une quelconque des revendications précédentes, **caractérisé en ce que** le dissipateur de chaleur (1) est composé d'aluminium ou de magnésium.

11. Procédé de fabrication d'un assemblage de refroidissement, comprenant les étapes ci-dessous :
- fourniture (20) d'un dissipateur de chaleur (1), comportant plusieurs ailettes (4) débordant d'un côté (10) du dissipateur de chaleur (1) ;
- encastrement au moins partiel (21) d'une plaque à conductivité thermique (2) dans le dissipateur de chaleur (1) sur le côté (9) du dissipateur de chaleur (1) qui est opposé au côté (10) à partir duquel les ailettes (4) débordent;
- formation (22) de rainures allongées sur la plaque et sur le côté (9) du dissipateur de chaleur (1) qui est opposé au côté (10) à partir duquel les ailettes (4) débordent;
- insertion (23) d'au moins un conducteur de chaleur allongé (3) dans les rainures, de sorte que le conducteur de chaleur est en partie encastré dans le premier côté du dissipateur de chaleur et en partie encastré dans la plaque conductrice ;
- fixation (24) des conducteurs de chaleur (3) sur le dissipateur de chaleur (1) ;
- remplissage (25) des espaces autour des conducteurs de chaleur (3) ; et
- usinage (26) de la surface du côté (9) du dissipateur de chaleur (1) qui est opposé au côté (10) à partir duquel les ailettes (4) débordent.

12. Procédé selon la revendication 11, le procédé comprenant en outre l'étape de fixation d'un composant de génération de chaleur (5) sur l'assemblage de refroidissement, de sorte que le composant de génération de chaleur (5) est en contact thermique direct avec la plaque (2) et les conducteurs de chaleur (3).

13. Procédé selon les revendications 11 ou 12, dans lequel les conducteurs de chaleur (3) sont fixés sur le dissipateur de chaleur (1) par soudage.

14. Procédé selon l'une quelconque des revendications 11 à 13, dans lequel les espaces autour des conducteurs de chaleur (3) sont remplis de soudure.
